(19) Europäisches Patentamt
European Patent Office
Office européen des brevets

(11) **EP 4 773 513 A1**

(12) **EUROPEAN PATENT APPLICATION**
published in accordance with Art. 153(4) EPC

(43) Date of publication:
**08.07.2026 Bulletin 2026/28**

(21) Application number: **24870565.9**

(22) Date of filing: **19.09.2024**

(51) International Patent Classification (IPC):
**H03M 1/12** (2006.01)          **H03M 1/44** (2006.01)
**H03M 1/00** (2006.01)

(86) International application number:
**PCT/CN2024/119774**

(87) International publication number:
**WO 2025/067021 (03.04.2025 Gazette 2025/14)**

(84) Designated Contracting States:
**AL AT BE BG CH CY CZ DE DK EE ES FI FR GB
GR HR HU IE IS IT LI LT LU LV MC ME MK MT NL
NO PL PT RO RS SE SI SK SM TR**
Designated Extension States:
**BA**
Designated Validation States:
**GE KH MA MD TN**

(30) Priority: **26.09.2023   CN 202311258513**

(71) Applicants:
• **Xi'an Chipsea Microelectronics Technology Co.,
Ltd
Shaanxi 710000 (CN)**

• **Chipsea Technologies (Shenzhen) Corp.
Shenzhen, Guangdong 518000 (CN)**

(72) Inventors:
• **XI, Wang
Xi'an, Shaanxi 710000 (CN)**
• **CHU, Xiaofeng
Xi'an, Shaanxi 710000 (CN)**

(74) Representative: **Berggren Oy
P.O. Box 16
Fabianinkatu 21
00101 Helsinki (FI)**

(54) **DIGITAL-TO-ANALOG CONVERTER, ANALOG-TO-DIGITAL CONVERTER, CHIP, AND ELECTRONIC DEVICE**

(57) Embodiments of the present application provide a digital-to-analog converter, an analog-to-digital converter, a chip, and an electronic device. The digital-to-analog converter includes: a first switch capacitor unit comprising a first capacitor network; and a second switch capacitor unit comprising a second capacitor network. The second switch capacitor unit is configured to redistribute charge on first plates of the second capacitor network and output a common-mode voltage, and the first switch capacitor unit is configured to, during a sampling phase, apply an analog input voltage to second plates of the first capacitor network and redistribute charge on first plates of the first capacitor network to output the common-mode voltage.

FIG. 1

FIG. 2

**EP 4 773 513 A1**

## Description

This application claims priority to Chinese Patent Application No. 202311258513.8, filed with the Chinese Patent Office on September 26, 2023, titled "DIGITAL-TO-ANALOG CONVERTER, ANALOG-TO-DIGITAL CONVERTER, CHIP, AND ELECTRONIC DEVICE". The disclosure of the abovementioned application is incorporated herein by reference in its entirety.

## TECHNICAL FIELD

Some embodiments of the present application relate to, but not limited to, integrated circuit technologies, and in particular to a digital-to-analog converter, an analog-to-digital converter, a chip, and an electronic device.

## BACKGROUND

Currently, a successive approximation analog-to-digital converter (SAR ADC) mainly includes a digital-to-analog converter (DAC), a common-mode voltage generation module, a comparator, and a logic module. In the SAR ADC, the DAC is typically a capacitive DAC which can generate an analog output voltage, the comparator can compare the analog output voltage with a common-mode voltage output by the common-mode voltage generation module, and the logic module can determine, based on the comparator's output result, an output code value for the next comparison cycle, to control a voltage to be applied to a plate at one end of each of a plurality of capacitors in the capacitive DAC, so that the capacitive DAC can output the analog output voltage of another voltage value. The above process can be repeated until the analog output voltage equals the common-mode voltage. Finally, a digital signal after conversion can be obtained from the logic module.

Before outputting the analog output voltage, the DAC needs to sample an input voltage signal. Specifically, it is necessary to apply the input voltage signal to a lower plate of each of the plurality of capacitors and apply the common-mode voltage to an upper plate of each of the plurality of capacitors. The sampling establishment will be completed upon the quantity of charge on either of the lower and upper plates of each of the plurality of capacitors stabilizes. After the sampling is completed, the common-mode voltage should be no longer applied to respective upper plates of the capacitors, so that the above process of the comparison by the comparator and the logic control by the logic module can be performed repeatedly.

## TECHNICAL PROBLEM

As described above, the DAC generally needs to rely on an external common-mode voltage generation module to complete the sampling establishment. For this end, however, the common-mode voltage generation module needs to have required establishment speed and output accuracy for the common-mode voltage and required anti-interference capability, which will lead to a complex circuit structure of the SAR ADC.

## TECHNICAL SOLUTIONS

In view of the above problem, the embodiments of the present application provide a digital-to-analog converter, an analog-to-digital converter, a chip, and an electronic device.

In a first aspect, a digital-to-analog converter is provided according to some embodiments of the present application. The digital-to-analog converter includes: a first switch capacitor unit comprising a first capacitor network; a second switch capacitor unit comprising a second capacitor network. The second switch capacitor unit is configured to redistribute charge on first plates of the second capacitor network and output a common-mode voltage; and the first switch capacitor unit is configured to, during a sampling phase, apply an analog input voltage to second plates of the first capacitor network and redistribute charge on first plates of the first capacitor network to output the common-mode voltage.

In a second aspect, an analog-to-digital converter is provided according to some embodiments of the present application. The analog-to-digital converter includes the digital-to-analog converter of the first aspect.

In a third aspect, a chip is provided according to some embodiments of the present application. The chip includes the analog-to-digital converter of the second aspect.

In a fourth aspect, an electronic device is provided according to some embodiments of the present application. The electronic device includes a device body and the chip of the third aspect disposed in the device body.

These or other aspects of the present application will become more apparent from the following description of the embodiments.

## BRIEF DESCRIPTION OF THE DRAWINGS

To more clearly illustrate the technical solutions in the embodiments or prior art, the accompanying drawings used in the description of the embodiments or prior art will be briefly introduced below. Obviously, the drawings described below are merely some embodiments of the invention. For those skilled in the art, other drawings can be obtained based on these drawings without any creative effort.

FIG. 1 schematically shows a circuit structure of a successive approximation analog-to-digital converter in the conventional art.

FIG. 2 is a schematical block diagram of an analog-to-digital converter according to some embodiments of the present application.

FIG. 3 is a schematical block diagram of a digital-to-analog converter according to some embodiments of the present application.

FIG. 4 schematically shows an example of redistribution of charge on first-side plates of a first capacitor network according to some embodiments of the present application.

FIG. 5 schematically shows another example of redistribution of charge on first-side plates of a first capacitor network according to some embodiments of the present application.

FIG. 6 is a schematical block diagram of an example of a first switch capacitor unit according to some embodiments of the present application.

FIG. 7 schematically shows an example of a circuit of a first switch capacitor unit according to some embodiments of the present application.

FIG. 8 schematically shows another example of a circuit of a first switch capacitor unit according to some embodiments of the present application.

FIG. 9 schematically shows a state of a first switch capacitor unit according to some embodiments of the present application.

FIG. 10 schematically shows another state of a first switch capacitor unit according to some embodiments of the present application.

FIG. 11 is a schematical block diagram of a second switch capacitor unit according to some embodiments of the present application.

FIG. 12 schematically shows an example of a circuit of a second switch capacitor unit according to some embodiments of the present application.

FIG. 13 schematically shows another example of a circuit of a second switch capacitor unit according to some embodiments of the present application.

FIG. 14 schematically shows an state of a second switch capacitor unit according to some embodiments of the present application.

FIG. 15 schematically shows another state of a second switch capacitor unit according to some embodiments of the present application.

FIG. 16 schematically shows an example of a circuit of a digital-to-analog converter according to some embodiments of the present application.

FIG. 17 schematically shows another example of a circuit of a digital-to-analog converter according to some embodiments of the present application.

FIG. 18 is a schematical block diagram of another example of a first switch capacitor unit according to some embodiments of the present application.

FIG. 19 schematically shows yet another example of a circuit of a first switch capacitor unit according to some embodiments of the present application.

Herein: 10-first switch capacitor unit, 11-first capacitor network, 12-first switch network, 13-second switch network; 20-second switch capacitor unit, 21-second capacitor network, 22-third switch network; C11, ..., Cln-first capacitor, S01-first redistribution switch, V1-first preset voltage, V2-second preset voltage, S1-first switch, S2-second switch, S11, ..., Sln-first control switch; Vref-reference voltage, VDD-power supply voltage, gnd-ground terminal, VIN-analog input voltage, Vcm-common-mode voltage, Vdac-analog output voltage; C1-first weighted capacitor, C2-second weighted capacitor, C3-third weighted capacitor, C4-fourth weighted capacitor; C21, ..., C2n-second capacitor, S02-second redistribution switch, V3-third preset voltage, V4-fourth preset voltage, S3-third switch, S4-fourth switch, S21, ..., S2n-second control switch, V5-preset holding voltage; 100-digital-to-analog convertor, 200-comparator, 300-logic module.

## DETAILED DESCRIPTION OF EMBODIMENTS OF THE PRESENT APPLICATION

The embodiments of the present application are described in detail below. Examples of the embodiments are shown in the accompanying drawings, where the same or similar reference numerals denote the same or similar elements or elements having the same or similar functions throughout. The embodiments described below with reference to the accompanying drawings are exemplary and are only used to illustrate the present application, and should not be construed as limiting the present application.

To enable those skilled in the art to better understand the solutions of the present application, the technical solutions of the embodiments of the present application will be clearly and completely described below with reference to the accompanying drawings. Obviously, the described embodiments are only a part of the embodiments of the present application, and not all of them. All other embodiments obtained by those skilled in the art based on the embodiments of the present application without creative effort are within the scope of protection of the present application.

In the embodiments of the present application, it should be noted that relational terms here such as first and second are used only to distinguish one entity or operation from another entity or operation, and do not necessarily require or imply any such actual relationship or order between these entities or operations.

Furthermore, the terms "comprising", "including" or any other variations thereof are intended to cover non-exclusive inclusion, such that a process, method, article, or apparatus that comprises a list of elements includes not only those elements but also other elements not expressly listed, or elements inherent to such a process, method, article, or apparatus. Without further limitation, an element defined by the phrase "comprising a ..." does not exclude the presence of other identical elements in the process, method, article, or apparatus that includes said element.

In the description of the embodiments of the present application, the words "example" or "for example" are used to indicate exemplification, illustration, or description. Any embodiment or design described as "example" or "for example" in the embodiments of the present application is not to be construed as being more preferred or having more advantages than another embodiment or design. The use of the words "example" or "for example" is intended to present relative concepts in a clear manner.

Furthermore, in the embodiments of the present application, "a plurality of" refers to two or more. Therefore, in the embodiments of the present application, "a plurality of" may also be understood as "at least two". "At least one" may be understood as one or more, such as one, two, or more. For example, including at least one means including one, two, or more, and is not limited to which ones are included. For example, including at least one of A, B or C, then it could include A, B, C, A and B, A and C, B and C, or A and B and C.

It should be noted that in the embodiments of the present application, "connection" may be understood as electrical connection. The connection between two electrical components may be a direct or indirect connection between the two electrical components. For example, the connection between A and B may be a direct connection between A and B, or an indirect connection between A and B through one or more other electrical components.

In the embodiments of the present application, the first terminal/first end of each transistor is one of the source and the drain of the transistor, and the second terminal/second end of each transistor is the other one of the source and the drain of the transistor. Since the source and drain of a transistor may be structurally symmetrical, they may be structurally indistinguishable. That is, the first terminal/first end and the second terminal/second end of the transistor in the embodiments of the present application may be structurally indistinguishable. For example, when the transistor is a P-type transistor, the first terminal/first end is the source of the transistor, and the second terminal/second end is the drain of the transistor. For another example, when the transistor is an N-type transistor, the first terminal/first end is the drain of the transistor, and the second terminal/second end is the source of the transistor.

In the circuit structure provided by the embodiments of the present application, nodes such as the first node and the second node do not represent actual existing components, but rather represent the junction points of related couplings in the circuit diagram. In other words, these nodes are equivalent to the junction points of related couplings in the circuit diagram.

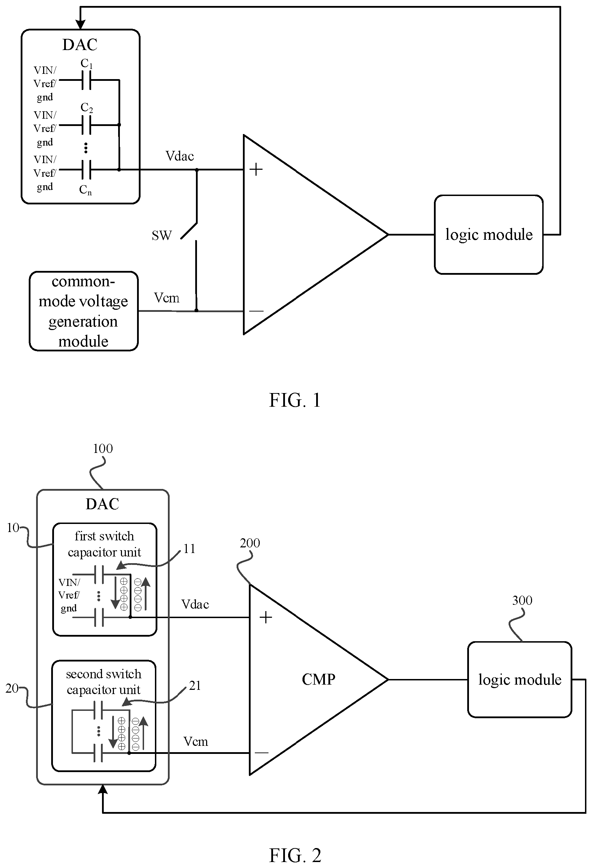

Currently, analog-to-digital converters (ADCs) are adapted in the fields such as communication, control, signal processing, and computer systems. An ADC can convert an analog input voltage signal into a digital signal and outputs that digital signal for use in a digital system. Taking a successive approximation ADC (SAR ADC) as an example, referring to FIG. 1, which schematically shows a circuit structure of a successive approximation analog-to-digital converter in the conventional art, the SAR ADC mainly consists of a digital-to-analog converter (DAC), a common-mode voltage generation module, a comparator, and a logic module.

The DAC mainly consists of a plurality of sampling capacitors $C_1$, $C_2$ ... Cn connected in parallel. The lower plate of each sampling capacitor $C_1$, $C_2$ ... Cn is controlled by a switch (not shown in the drawings) to receive an analog input voltage VIN, a reference voltage Vref, or a ground gnd. The upper plate of each sampling capacitor $C_1$, $C_2$ ... Cn is connected to the non-inverting input of the comparator. The DAC outputs an analog output voltage Vdac to the non-inverting input of the comparator. A switch SW is connected between the non-inverting and inverting inputs of the comparator. The common-mode voltage generation module generates a common-mode voltage Vcm, which is then output to the inverting input of the comparator.

During the sampling phase, the switch SW is closed, the lower plates of sampling capacitor $C_1$, $C_2$ ... Cn receives the analog input voltage Vin, and the upper plates are connected to the output of the common-mode voltage generation module through the switch SW to receive the common-mode voltage Vcm. After the sampling establishment is fully completed, Vdac = Vcm is satisfied, and the voltage across the sampling capacitor equals (Vcm - Vin).

During the conversion phase, the lower plate of the sampling capacitor no longer receives the analog input voltage, but instead receives the reference voltage or grounded according to logic control, and the switch SW is simultaneously opened. At this time, the voltage Vdac at the non-inverting input of the comparator equals (Vref × Ceq / Ctotal - VIN + Vcm), where Ceq is the capacitance of the sampling capacitor whose lower plate receives the reference voltage Vref, and Ctotal is the total capacitance of the entire sampling capacitor array of $C_1$, $C_2$ ... Cn; while the voltage at the inverting input of the comparator is the common-mode voltage Vcm.

During the comparison process of the comparator, the term Vem, as the common-mode voltage, is eliminated during the transcoding comparison. The comparator is actually determining the sign of (Vref × Ceq / Ctotal -VIN). Based on the comparator's output, the logic module determines the output code value for the next comparison cycle to control the capacitance of the sampling capacitor Ceq. This causes the voltage Vdac at the non-inverting input of the comparator to successively approach the common-mode voltage Vcm until the analog output voltage Vdac equals the common-mode voltage Vcm. Finally, the digital signal is obtained through the conversion from the logic module.

However, since the DAC rely on an external common-mode voltage generation module to complete the sampling establishment, and the common-mode voltage generation module has requirements for establishment speed, output accuracy, and anti-interference of the common-mode voltage, this will lead to increased complexity in the circuit structure of the SAR ADC.

Before introducing the digital-to-analog converters, analog-to-digital converters, chips, and electronic devices of the present application, it is firstly introduced the background information of the application scenario of the voltage buffer according to the embodiments of the present application.

Referring to FIG. 2, which is a schematical block diagram of an analog-to-digital converter (ADC) according to some embodiments of the present application, the ADC includes a digital-to-analog converter (DAC) 100, a comparator 200, and a logic module 300. The second switch capacitor unit 20 of the DAC 100 can provide a common-mode voltage Vcm to the inverting input of the comparator 200. Simultaneously, the first switch capacitor unit 10 of the DAC 100 can establish sampling of the common-mode voltage Vcm through charge redistribution on first-side plates of the first switch capacitor unite 10. That is, during the ADC converting the analog signal to a digital signal, it is unnecessary to apply the common-mode voltage Vcm to the first-side plates of the first capacitor network 11. The charge redistributions are respectively performed on the first-side plates of the first capacitor network 11 and on the first-side plates of the second capacitor network 21 to complete the sampling of the analog input voltage VIN, while simultaneously providing the common-mode voltage Vem. On one hand, this eliminates the need for a generation module of the common-mode voltage Vcm in the ADC, simplifying the circuit structure of the ADC. On the other hand, due to the common-mode voltage Vcm is provided through the charge redistribution, the outputting of the common-mode voltage Vcm consumes virtually no power, thus reducing the power consumption of the ADC.

It should be understood that the ADC can also be a hybrid structure ADC consisting of a SAR ADC and other ADCs, such as a pipeline SAR ADC, incremental SAR ADC, delta-sigma SAR ADC, etc.

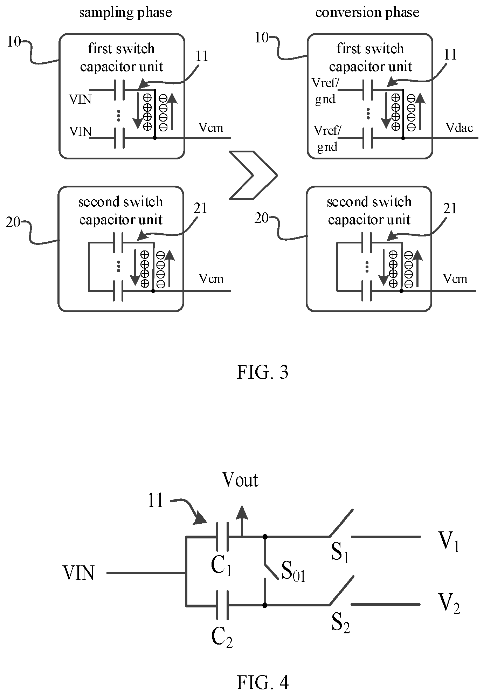

Referring to FIG. 3, which shows schematical block diagram of the DAC 100 according to some embodiments of the present application, the DAC 100 includes: a first switch capacitor unit 10 which includes a first capacitor network 11; and a second switch capacitor unit 20 which includes a second capacitor network 21. The second switch capacitor unit 20 is configured to redistribute the charges on the first-side plates of the second capacitor network 21 to output a common-mode voltage Vem, and the first switch capacitor unit 10 is configured to, during the sampling phase, apply the analog input voltage VIN to the second-side plates of the first capacitor network 11, and redistribute charges on the first-side plates of the first capacitor network 11 to output the common-mode voltage Vcm.

In this embodiment, the first switch capacitor unit 10 can enable the charge redistribution of the first-side plates of the first capacitor network 11 through the control of the switch, so that when the second-side plates of the first capacitor network 11 receive the analog input voltage VIN (i.e., the sampling phase), the first-side plates output the common-mode voltage Vcm to complete the sampling establishment, or when the second-side plates of the first capacitor network 11 receive the reference voltage Vref or grounded (i.e., the conversion phase), the first-side plates output an analog output voltage Vdac.

In some embodiments of the present application, the first capacitor network 11 may include a plurality of capacitors connected in parallel. In some embodiments of the present application, the first capacitor network 11 may include a plurality of capacitors connected in parallel and partially connected in series, for example, in a plurality of parallel branches, one parallel branch has two or more capacitors connected in series.

In some embodiments of the present application, the charge redistribution of the first-side plates of the first capacitor network 11 can be achieved by transferring charges between capacitors within the first capacitor network 11. For example, referring to FIG. 4, which schematically shows an example of charge redistribution on first-side plates of the first capacitor network 11 according to some embodiments of the present application, when switches $S_1$ and $S_2$ are closed and switch $S_{01}$ is open, a voltage $V_1$ charges capacitor $C_1$ and a voltage $V_2$ charges capacitor $C_2$. After charging is completed, the charges of capacitor $C_1$ equals $(V_1 - VIN) \times C_1$ and the charges of capacitor $C_2$ equals $(V_2 - VIN) \times C_2$. Then, switches $S_1$ and $S_2$ are opened and switch $S_{01}$ is closed. According to the principle of charge redistribution and charge conservation, the following formula can be obtained:

$$(Vout - VIN) \times (C_1 + C_2) = (V_1 - VIN) \times C_1 + (V_2 - VIN) \times C_2 .$$

After simplifying the above formula, the following formula can be obtained:

$$Vout = V_1 \times C_1 + V_2 \times C_2 .$$

In other words, by controlling the values of voltages $V_1$ and $V_2$, and the capacitances of capacitors $C_1$ and $C_2$, the magnitude of the output voltage Vout can be controlled, thereby enabling the charge redistribution of the first-side plates of the first capacitor network 11 and the output of the common-mode voltage Vcm.

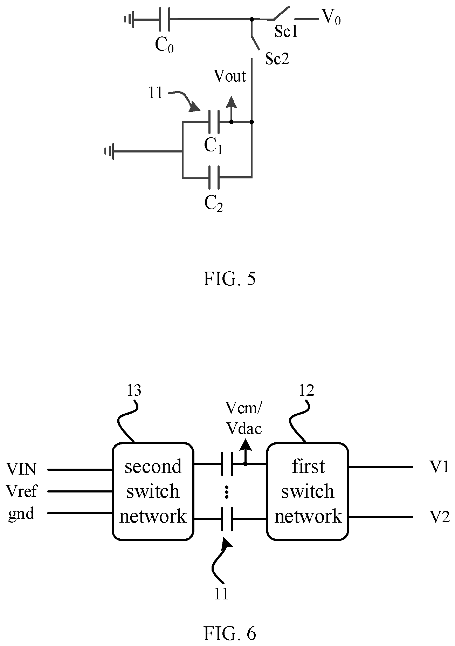

In some embodiments of the present application, the charge redistribution of the first-side plates of the first capacitor network 11 can be achieved by transferring charges through an external capacitor independent of the first capacitor network 11. For example, referring to FIG. 5, which schematically shows another example of charge redistribution on first-side plates of the first capacitor network according to some embodiments of the present application, when the switch Sc1 is closed and Sc2 is open, a voltage $V_0$ charges capacitor $C_0$ outside the first capacitor network 11. After charging is completed, the charges of capacitor $C_0$ equals $V_0 \times C_0$. Then, the switch Sc1 is opened and Sc2 is closed. According to the principle of charge redistribution and charge conservation, the following formula can be obtained:

$$Vout \times (C_1 + C_2 + C_0) = V_0 \times C_0 .$$

After converting the above formula, the output voltage Vout can be determined as:

$$Vout = V_0 \times C_0 / (C_1 + C_2 + C_0) .$$

In other words, by controlling the value of the voltage $V_0$ and the capacitances of capacitors $C_1$, $C_2$, and $C_0$, the magnitude of the output voltage Vout can be controlled, thereby enabling the charge redistribution of the first-side plates of the first capacitor network 11 and the output of the common-mode voltage Vcm.

The second switch capacitor unit 20 can enable the charge redistribution of the first-side plates of the second capacitor network 21 through the control of the switch, to provide a common-mode voltage Vcm to the inverting input of the comparator 200. In some embodiments of the present application, the second capacitor network 21 may include a plurality of capacitors connected in parallel. In some embodiments of the present application, the second capacitor network 21 may include a plurality of capacitors connected in parallel and partially connected in series; for example, in a plurality of parallel branches, one parallel branch has two or more capacitors connected in series.

In some embodiments of the present application, the charge redistribution of the first-side plates of the second capacitor network 21 can be achieved by transferring charges between capacitors within the second capacitor network 21. In some embodiments of the present application, the charge redistribution of the first-side plates of the first capacitor network 11 can be achieved by transferring charges through an external capacitor independent of the first capacitor network 11.

It should be noted that the first-side plates and the second-side plates refer to the plates on the same side of the capacitor network (e.g., the first capacitor network 11 or the second capacitor network 21). For example, the first-side plates can refer to the upper plates of a plurality of capacitors connected in parallel in the capacitor network, and the second-side plates can refer to the lower plates of a plurality of capacitors connected in parallel in the capacitor network.

In some embodiments of the present application, the first-side plates of the first capacitor network 11 may refer to the upper plates of a plurality of capacitors connected in parallel in the first capacitor network 11, and the second-side plates of the first capacitor network 11 may refer to the lower plates of the plurality of capacitors connected in parallel in the first capacitor network 11. The first-side plates of the second capacitor network 21 may refer to the upper plates of a plurality of capacitors connected in parallel in the second capacitor network 21, and the second-side plates of the second capacitor network 21 may refer to the lower plates of the plurality of capacitors connected in parallel in the second capacitor network 21.

In some embodiments of the present application, the first-side plates of the first capacitor network 11 may refer to the upper plates of a plurality of capacitors connected in parallel in the first capacitor network 11, and the second-side plates of the first capacitor network 11 may refer to the lower plates of the plurality of capacitors connected in parallel in the first capacitor network 11. The first-side plates of the second capacitor network 21 may refer to the lower plates of a plurality of capacitors connected in parallel in the second capacitor network 21, and the second-side plates of the second capacitor network 21 may refer to the upper plates of the plurality of capacitors connected in parallel in the second capacitor network 21.

It should be understood that the first-side plates of the first capacitor network 11 may refer to the lower plates of a plurality of capacitors connected in parallel in the first capacitor network 11, and the second-side plates of the first capacitor network 11 may refer to the upper plates of the plurality of capacitors connected in parallel in the first capacitor network 11; while the first-side plates of the second capacitor network 21 may refer to the upper plates of a plurality of capacitors connected in parallel in the second capacitor network 21, and the second-side plates of the second capacitor network 21 may refer to the lower plates of the plurality of capacitors connected in parallel in the second capacitor network 21.

According to the embodiments of the present application, the DAC 100 applies the analog input voltage VIN to the second-side plates of the first capacitor network 11 during the sampling phase, so as to enable the charge redistribution of the first-side plates of the first capacitor network 11 to generate a common-mode voltage Vcm. At the same time, the second switch capacitor unit 20 is utilized to enable charge redistribution of the first-side plates of the second capacitor network 21 to provide the common-mode voltage Vcm, thereby completing the sampling establishment of the ADC for the analog input voltage VIN. In other words, during the sampling establishment, there is no need for an external common-mode voltage generation module to provide the common-mode voltage Vcm, nor is it necessary to apply the common-mode voltage Vcm to the first-side plates of the first capacitor network 11. The charge redistributions are respectively performed on the first-side plates of the first capacitor network 11 and on the first-side plates of the second capacitor network 21 to complete the sampling of the analog input voltage VIN. On one hand, this eliminates the need for a generation module for the common-mode voltage Vcm in the ADC (such as a SAR ADC), simplifying the circuit structure of the ADC. On the other hand, due to the common-mode voltage Vcm is provided through the charge redistribution, the outputting of the common-mode voltage Vcm consumes virtually no power, thus reducing the ADC's energy consumption.

In some embodiments of the present application, referring to FIG. 6, which is a schematical block diagram of an example of a first switch capacitor unit 10 according to some embodiments of the present application, the first switch capacitor unit 10 further includes a first switch network 12 and a second switch network 13. The first switch network 12 is connected to the first-side plates of the first capacitor network 11, and the second switch network 13 is connected to the second-side plates of the first capacitor network 11. The first switch network 12 is used to control the charge redistribution of the first-side plates and output a common-mode voltage Vcm, and the second switch network 13 is used to change the voltages respectively connected to the second-side plates so as to enable another charge redistribution of the first-side plates and an analog output signal of a voltage Vdac.

It should be noted that when the DAC 100 is performing the sampling, the second switch network 13 controls the second-side plates of the first capacitor network 11 to receive the analog input voltage VIN, and the first switch network 12 controls the charge redistribution of the first-side plates and outputs the common-mode voltage Vcm. At this time, the voltages across each capacitor in the first capacitor network 11 is the analog input voltage VIN and the common-mode voltage Vcm, respectively, thus completing the sampling establishment of the DAC 100. When the DAC 100 is performing the conversion, the second switch network 13 changes the voltages connected to the second-side plates of capacitors in the first capacitor network 11, for example, the second-side plates of some capacitors is grounded, and the second-side plates of some capacitors receives the reference voltage Vref. The charges on the first-side plate of the grounded capacitor will be redistributed to the first-side plate of the capacitor receiving the reference voltage Vref, thereby changing the potential of the first-side plates of the first capacitor network 11 and finally providing the analog output signal of the voltage Vdac to the non-inverting input terminal of the comparator 200.

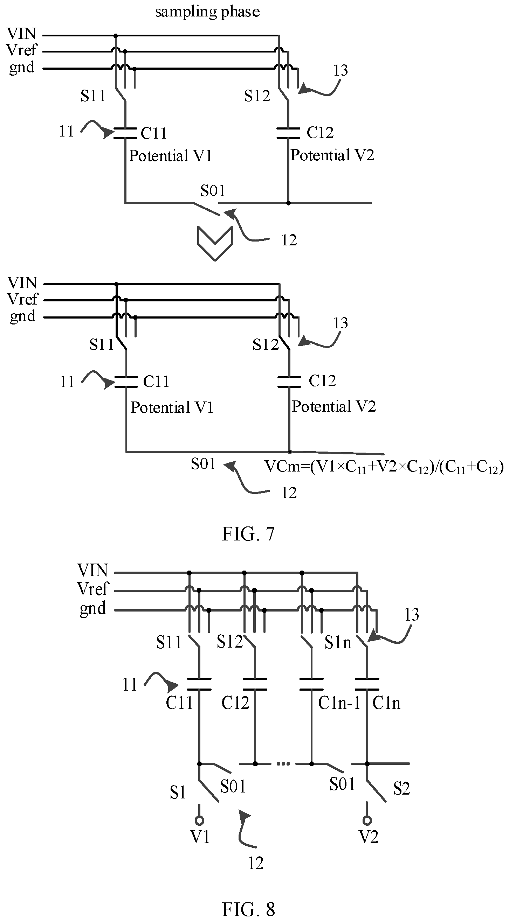

In some embodiments of the present application, referring to FIG. 7, which schematically shows a circuit of a first switch capacitor unit 10 according to some embodiments of the present application, the first capacitor network 11 includes a plurality of first capacitors, and the first-side plates of the plurality of first capacitors are interconnected; the first switch network 12 includes at least one first redistribution switch S01, which is used to control the connection or disconnection between the first-side plates of adjacent first capacitors; when the first redistribution switch S01 is open, the potentials of the first-side plates of at least two first capacitors are not equal; when the first redistribution switch S01 is closed, the charge on the first-side plates of the plurality of first capacitors is redistributed.

For example, referring to FIG. 7, when the first redistribution switch S01 is open, the potential of the first-side plate of the first capacitor C11 is V1, and the potential of the first-side plate of the first capacitor C12 is V2. When the first redistribution switch S01 is closed, the charges on the first-side plates of the first capacitor C11 and the first capacitor C12 is redistributed. At this time, the potentials of the first-side plates of the first capacitor C11 and the first capacitor C12 changes, so that the common mode voltage Vcm output by the first switch capacitor unit 10 satisfies $Vcm = (V1 \times C11 + V2 \times C12) / (C11 + C12)$.

When the DAC 100 is performing the sampling, the first redistribution switch S01 remains closed, and switches S11 and S12 in the second switch network 13 control the second-side plates of the first capacitor C11 and the first capacitor C12 to receive the analog input voltage VIN. Then, the voltages across each of the first capacitor C11 and the first capacitor C12 are the analog input voltage VIN and the common-mode voltage Vcm, respectively, thus completing the sampling establishment of the DAC 100. When the DAC 100 is performing the conversion, the switches S11 and S12 change the voltages apply to the second-side plates of the capacitors in the first capacitor network 11. For example, the second-side plate of the first capacitor C11 is grounded, and the second-side plate of the first capacitor C12 receives the reference voltage Vref. Then, the charges on the first-side plate of the first capacitor C11 will be redistributed to the first-side plate of the first capacitor C12, thereby changing the potentials of the first-side plates of the first capacitors C11 and C12, and finally providing the analog output signal of the voltage Vdac to the non-inverting input of the comparator 200.

In some embodiments of the present application, referring to FIG. 8, which schematically shows another circuit of a first switch capacitor unit 10 according to some embodiments of the present application, the first redistribution switch S01 is provided between the first-side plates of each two adjacent first capacitors. When the DAC 100 is in the sampling phase, at most one first redistribution switch S01 is configured to be open and then closed.

It should be noted that since at most one first redistribution switch S01 is configured to be open and then closed, the plurality of first capacitors can be divided into two parts. One part of the capacitors connected in parallel can be equivalent to one weighted capacitor , and the other part of the capacitors connected in parallel can be equivalent to another weighted capacitor. The first redistribution switch S01 configured to be open and then closed separates the two weighted capacitors. By changing the position of the first redistribution switch S01 configured to be open and then closed, the capacitances of the weighted capacitors can be changed, thereby changing the magnitude of the common mode voltage Vcm.

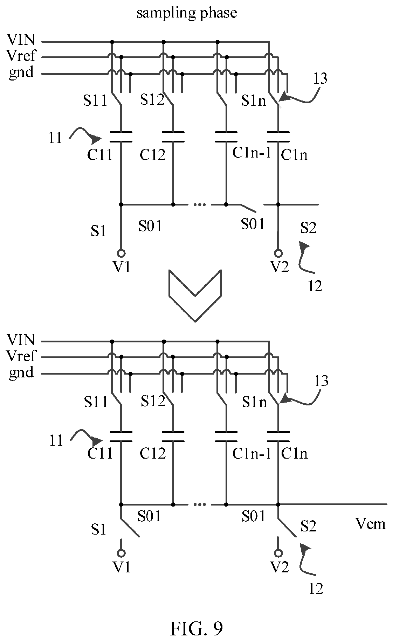

As an example, referring to FIG. 9, which schematically shows a state of a first switch capacitor unit 10 according to some embodiments of the present application, when the first redistribution switch S01 configured to be open and then closed is located between the first-side plate of the first capacitor C1n-1 and the first capacitor C1n, the capacitance of one weighted capacitor equals the sum of the capacitances of the first capacitors C12, C13, ..., and C1n-1, and the capacitance of the other weighted capacitor equals the capacitance of the first capacitor C1n. If, before the first redistribution switch S01 is closed, the voltage of the first-side plates of the first capacitors C12, C13, ..., and C1n-1 is V1, and the voltage of the first-side plate of the first capacitor C1n is V2, then after the first redistribution switch S01 is closed, the magnitude of the common-mode voltage Vcm satisfies the following relationship:

$$\text{Vcm} = (\text{V1} \times (\text{C11} + \text{C12} ... + \text{C1}(n\text{-}1)) + \text{V2} \times \text{C1n}) / (\text{C11} + \text{C12} ... + \text{C1n}) .$$

It should be understood that when the position of the first redistribution switch S01 is changed, the capacitance of the weighted capacitor is changed, and the magnitude of the common-mode voltage Vcm can be adjusted without changing the voltages.

In some embodiments of the present application, referring to FIG. 8, a plurality of first capacitors are arranged in sequence, the first-side plate of the first capacitor at the first position of the sequence is configured to receive a first preset voltage V1, and the first-side plate of the first capacitor at the last position of the sequence is configured to receive a second preset voltage V2; where the first preset voltage V1 and the second preset voltage V2 are not equal.

It should be noted that, since the first-side plate of the first capacitor at the first position of the sequence is configured to receive the signal the first preset voltage V1, and the first-side plate of the first capacitor at the last position of the sequence is configured to receive the second preset voltage V2, when any one of the first redistribution switches S01 is configured to be open and then closed, the first-side plates of all the first capacitors can receive the first preset voltage V1 or the second preset voltage V2 for charging. Then, after the first redistribution switch S01 is closed, the charge redistribution is performed, thus avoiding the phenomenon that the first preset voltage V1 is applied to the first-side plate of the middle first capacitor (e.g., the first capacitor C12) and causes some first capacitors (e.g., the first capacitor C11) to be unable to be charged.

In some embodiments of the present application, referring to FIG. 8, the first switch network 12 further includes a first switch S1 and a second switch S2. One end of the first switch S1 is connected to the first-side plate of the first capacitor at the first position of the sequence, and the other end of the first switch S1 is configured to receive the first preset voltage V1. One end of the second switch S2 is connected to the first-side plate of the first capacitor at the last position of the sequence, and the other end of the second switch S2 is configured to receive the second preset voltage V2.

It should be noted that when the first switch S1 and the second switch S2 are closed, the first redistribution switch S01, which is configured to be open and then closed, is open, and the other first redistribution switches S01 are closed. At this time, the first preset voltage V1 charges part of the first capacitors, and the second preset voltage V2 charges the other part of the first capacitors. After the first switch S1 and the second switch S2 are open, the first redistribution switch S01, which is configured to be open and then closed, is closed. Therefore, the charges on the first-side plates of the first capacitors are redistributed, so that the voltage of the first-side plates of the first capacitors equals the common-mode voltage Vcm.

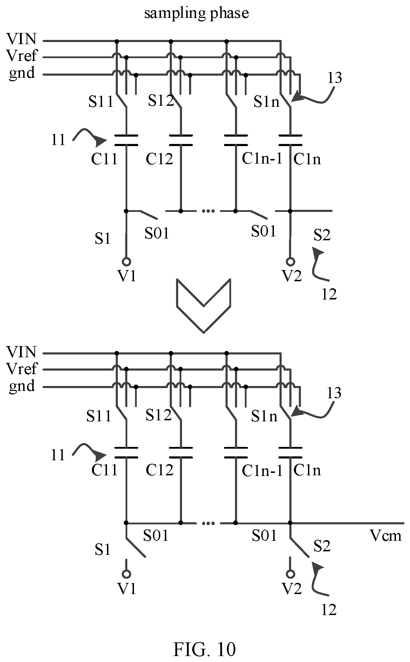

It should be understood that a plurality of first redistribution switches S01 can also be configured to be open and then closed simultaneously. For example, referring to FIG. 10, which schematically shows another state of a first switch capacitor unit 10 according to some embodiments of the present application, the first redistribution switch S01 between the first capacitor C11 and the first capacitor C12 is configured to be open and then closed, and the first redistribution switch S01 between the first capacitor C1(n-1) and the first capacitor C1n is configured to be open and then closed. That is, the first preset voltage V1 only charges the first capacitor C11, and the second preset voltage V2 only charges the first capacitor C1n. After the first switch S1 and the second switch S2 are open and all first redistribution switches S01 are closed, the output common-mode voltage Vcm satisfies:

$$Vcm = (V1 \times C11 + V2 \times C1n) / (C11 + C12 \dots + C1n).$$

In some embodiments of the present application, referring to FIG. 8 or FIG. 9, the second switch network 13 includes a plurality of first control switches S11-S1n, each first control switch corresponding to a first capacitor. The first control switch is used to control the second-side plate of the first capacitor to receive the analog input voltage VIN, the reference voltage Vref, or the ground. The first preset voltage V1 and the second preset voltage V2 are any two of the reference voltage Vref, the power supply voltage VDD, or 0 V.

It should be noted that when the first control switch controls the second-side plate of the first capacitor to receive the analog input voltage VIN, the first switch network 12 can be controlled for redistributing the charges of the first-side plates of the first capacitors and output the common-mode voltage Vem, thereby realizing the sampling of the analog input voltage VIN. When the first control switch controls the second-side plate of the first capacitor to receive the reference voltage Vref or ground, the switches of the first switch network 12 (e.g., the first switch S1, the second switch S2, or the first redistribution switches S01) remain unchanged. Since the second-side plates of some first capacitors are grounded and the second-side plates of some first capacitors receive the reference voltage Vref, the charges on the first-side plates of the grounded capacitors will be redistributed to the first-side plates of the capacitors receiving the reference voltage Vref, thereby changing the potential of the first-side plates of the first capacitor network 11 and finally providing the analog output voltage Vdac to the non-inverting input of the comparator 200.

Meanwhile, since the first preset voltage V1 and the second preset voltage V2 are any two of the reference voltage Vref, the power supply voltage VDD, or 0 V, and the reference voltage Vref, the power supply voltage VDD, and 0 V are all voltages inherent to the DAC 100, there is no need to generate the first preset voltage V1 and the second preset voltage V2 through extra circuits, which helps to simplify the circuit structure of the DAC 100.

For example, the first preset voltage V1 is the reference voltage Vref, and the second preset voltage V2 is 0 V. Since the reference voltage Vref of the DAC 100 has the characteristic of low noise, a more accurate signal of the common-mode voltage Vcm can be output by utilizing the signals of the reference voltage Vref and the 0V ground voltage, avoiding the error in the common-mode voltage Vcm due to the jitter of the power supply voltage VDD.

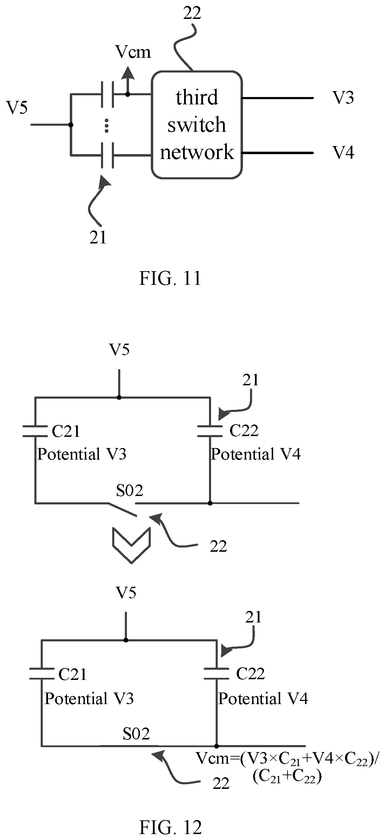

In some embodiments of the present application, referring to FIG. 11, which is a schematical block diagram of a second switch capacitor unit 20 according to some embodiments of the present application, the second switch capacitor unit 20 further includes a third switch network 22 connected to the first-side plates of the second capacitor network 21, and the second-side plates of the second capacitor network 21 receive a fifth preset voltage V5. The third switch network 22 is further receives signals of a third preset voltage V3 and a fourth preset voltage V4, and is used to control the charge redistribution of the first-side plates of the second capacitor network 21 and output a common-mode voltage Vcm.

In some embodiments of the present application, the third switch network 22 can control the charge redistribution of the first-side plates of the second capacitor network 21 and output a common-mode voltage Vcm during the sampling phase. In some embodiments of the present application, the third switch network 22 can control the charge redistribution of the first-side plates of the second capacitor network 21 and output a common-mode voltage Vcm during the conversion phase.

In some embodiments of the present application, referring to FIG. 12, which schematically shows a circuit of a second switch capacitor unit 20 according to some embodiments of the present application, the second capacitor network 21 includes a plurality of second capacitors, and the first-side plates of the second capacitors are interconnected; the third switch network 22 includes at least one second redistribution switch S02, which is used to control the connection or disconnection of the first-side plates between adjacent two of the second capacitors. When the second redistribution switch S02 is open, the potentials of the first-side plates of at least two second capacitors are not equal; when the second redistribution switch S02 is closed, the charges of the first-side plates of the second capacitors are redistributed.

For example, the potential of the first-side plate of the second capacitor C21 is V3, and the potential of the first-side plate of the second capacitor C22 is V4. When the second redistribution switch S02 is closed, the charges of the first-side plates of the second capacitor C21 and the second capacitor C22 are redistributed. At this time, the potentials of the first-side plates of the second capacitor C21 and the second capacitor C22 change, so that the common mode voltage Vcm output by the second switch capacitor unit 20 satisfies:

$$Vcm = (V3 \times C21 + V4 \times C22) / (C21 + C22) \,.$$

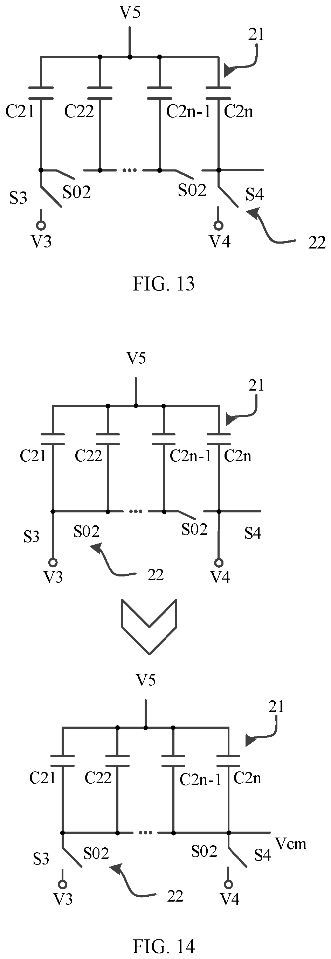

In some embodiments of the present application, referring to FIG. 13, which schematically shows another circuit of a second switch capacitor unit 20 according to some embodiments of the present application, a second redistribution switch S02 is provided between the first-side plates of any adjacent two of the second capacitors, and at most one second redistribution switch S02 is configured to be open and then closed.

It should be noted that since at most one second redistribution switch S02 is configured to be open and then closed, a plurality of second capacitors can be divided into two parts. One part of the second capacitors connected in parallel can be equivalent to one weighted capacitor, and the other part of the second capacitors connected in parallel can be equivalent to another weighted capacitor. The second redistribution switch S02 configured to be open and then closed separates the two weighted capacitors. By changing the position of the second redistribution switch S02 configured to be open and then closed, the capacitance of the weighted capacitors can be changed, thereby changing the magnitude of the common mode voltage Vcm.

As an example, referring to FIG. 14, which schematically shows a state of a second switch capacitor unit 20 according to some embodiments of the present application, when the first redistribution switch S01, which is configured to be open and then closed, is located between the first-side plates of the second capacitor C2n-1 and the second capacitor C2n. The capacitance of one weight capacitor equals the sum of the capacitances of the second capacitors C21, C22, ..., and C2n-1, and the capacitance of the other weight capacitor equals the capacitance of the second capacitor C2n. If, before the second redistribution switch S02 is closed, the voltage of the first-side plates of the second capacitors C21, C22, ..., C2n-1 is V3, and the voltage of the first-side plate of the second capacitor C2n is V4, then after the second redistribution switch S02 is closed, the magnitude of the common-mode voltage Vcm satisfies the following relationship:

$$Vcm = (V3 \times (C21 + C22 ... + C2n\text{-}1) + (V4 \times C2n)) / (C21 + C22 ... + C2n ) \,.$$

It should be understood that, when the position of the second redistribution switch S02 is changed, the capacitances of the weighted capacitors are changed, and the magnitude of the common-mode capacitor can be adjusted without changing the voltages.

In some embodiments of the present application, referring to FIG. 13, a plurality of second capacitors are arranged in sequence; the first-side plate of the second capacitor at the first position of the sequence is configured to receive the third preset voltage V3, and the first-side plate of the second capacitor at the last position of the sequence is configured to receive the fourth preset voltage V4; where the third preset voltage V3 and the fourth preset voltage V4 are not equal.

It should be noted that, since the first-side plate of the second capacitor at the first position of the sequence can receive the third preset voltage V3, and the first-side plate of the second capacitor at the last position of the sequence can receive the fourth preset voltage V4, when any one of the second redistribution switches S02 is configured to be open and then closed, the first-side plates of all the first capacitors can receive the third preset voltage V3 or the fourth preset voltage V4 for charging. Then, after the second redistribution switch S02 is closed, the charge redistribution is performed, thus avoiding the phenomenon that the third preset voltage V3 applies the first-side plate of the middle second capacitor (e.g., second capacitor C22) and causes some second capacitors (e.g., second capacitor C21) to be unable to be charged.

In some embodiments of the present application, referring to FIG. 13, the third switch network 22 further includes a third switch S3 and a fourth switch S4. One end of the third switch S3 is connected to the first-side plate of the second capacitor located at the first position of the sequence, and the other end of the third switch S3 is configured to receive the third preset voltage V3. One end of the fourth switch S4 is connected to the first-side plate of the second capacitor located at the last position of the sequence, and the other end of the fourth switch S4 is configured to receive a fourth preset voltage V4.

It should be noted that when the third switch S3 and the fourth switch S4 are closed, the second redistribution switch S02, which is configured to be open and then closed, is open, while the other second redistribution switches S02 are closed. At this time, third preset voltage V3 charges part of the second capacitors, and the fourth preset voltage V4 charges the other part of the second capacitors. After the third switch S3 and the fourth switch S4 are opened, the second redistribution switch S02, which is configured to be open after being closed, is closed. Therefore, the charges on the first-side plates of the second capacitors are redistributed, so that the voltage of the first-side plates of the second capacitors equals the common-mode voltage Vcm.

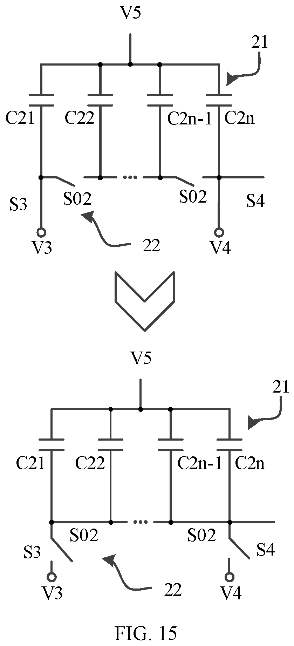

It should be understood that a plurality of second redistribution switches S02 can also be configured to be open and then closed simultaneously. For example, referring to FIG. 15, which schematically shows another state of a second switch capacitor unit 20 according to some embodiments of the present application, the second redistribution switch S02 between the second capacitor C21 and the second capacitor C22 is configured to be open and then closed, and the second redistribution switch S02 between the second capacitor C2n-1 and the second capacitor C2n is also configured to be open and then closed. That is, the third preset voltage V3 only charges the second capacitor C21, and the fourth preset voltage V4 only charges the second capacitor C2n. After the third switch S3 and the fourth switch S4 are open and all the first redistribution switches S01 are closed, the output signal of the common mode voltage Vcm satisfies:

$$\text{Vcm} = (\text{V3} \times \text{C21} + \text{V4} \times \text{C2n}) / (\text{C21} + \text{C22} \ldots + \text{C2n}).$$

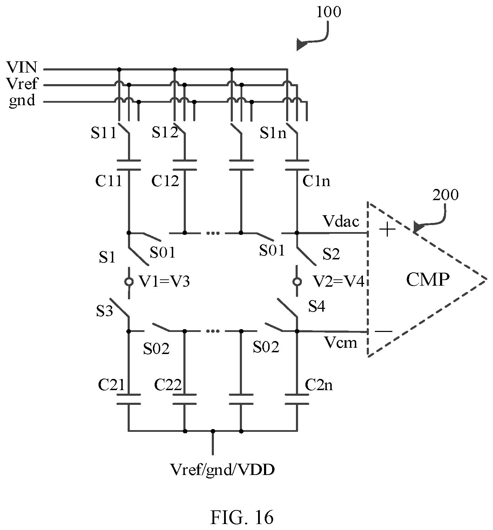

In some embodiments of the present application, referring to FIG. 16, which schematically shows a circuit of a DAC 100 according to some embodiments of the present application, the third preset voltage V3 and the fourth preset voltage V4 are any two of the reference voltage Vref, the power supply voltage VDD, or 0V, so that there is no need to generate the third preset voltage V3 and the fourth preset voltage V4 through the circuit structure, which helps to simplify the circuit structure of the DAC 100.

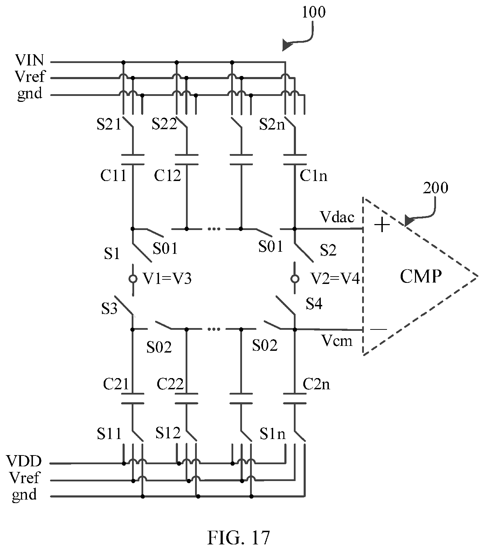

In some embodiments of the present application, referring to FIG. 13 and FIG. 17, where FIG. 17 schematically shows another circuit of a DAC according to some embodiments of the present application, the second-side plates of a plurality of second capacitors receive a preset holding voltage V5, and the preset holding voltage V5 is any one of a reference voltage Vref, a power supply voltage VDD, or 0 V.

In some other embodiments of the present application, referring to FIG. 17, which schematically shows another circuit of a DAC according to some embodiments of the present application, the second switch capacitor unit 20 further includes a fourth switch network including a plurality of second control switches S21-S2n each corresponding to a the second capacitor. The second control switch is used to control the second-side plate of the second capacitor to receive the reference voltage Vref or grounded.

When the second control switch controls the second-side plate of the second capacitor to receive the reference voltage Vref or grounded, the switches of the third switch network 22 (e.g., the first switch S1, the second switch S2, or the first redistribution switch S01) remain unchanged. Since some of the second-side plates of the second capacitors are grounded and some of the second-side plates of the second capacitors receive the reference voltage Vref, the charges on the first-side plates of the grounded second capacitors will be redistributed to the first-side plates of the second capacitors receiving the reference voltage Vref, thereby changing the potential of the first-side plates of the second capacitor network 21 and finally providing the common-mode voltage Vcm to the non-inverting input of the comparator 200.

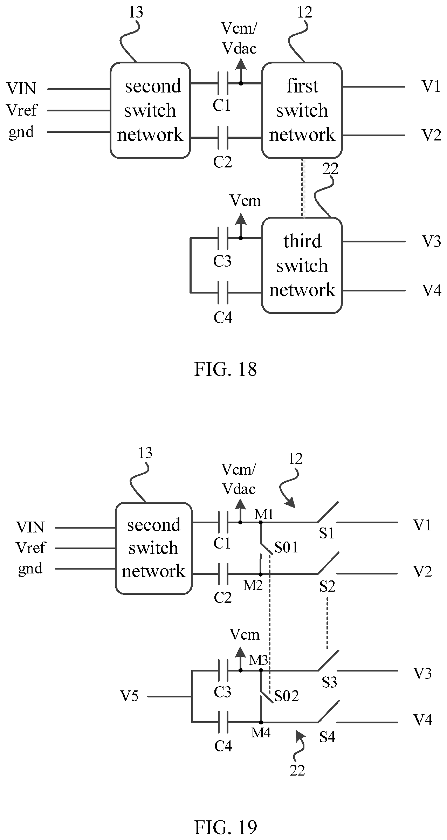

In some embodiments of the present application, referring to FIG. 18, which is a schematical block diagram of another example of a first switch capacitor unit 10 according to some embodiments of the present application, the first capacitor network 11 includes a first weighted capacitor C1 and a second weighted capacitor C2, and the second capacitor network 21 includes a third weighted capacitor C3 and a fourth weighted capacitor C4. The first-side plate of the first weighted capacitor C1 is configured to receive a first preset voltage V1, the first-side plate of the second weighted capacitor C2 is configured to receive a second preset voltage V2. The first-side plate of the third weighted capacitor C3 is configured to receive a third preset voltage V3, and the first-side plate of the fourth weighted capacitor C4 is configured to receive a fourth preset voltage V4. The first preset voltage V1, the second preset voltage V2, the third preset voltage V3, the fourth preset voltage V4, the first weighted capacitor C1, the second weighted capacitor C2, the third weighted capacitor C3, and the fourth weighted capacitor C4 satisfy the following relationship:

$$\text{C1} \times \text{V1} + \text{C2} \times \text{V2} = \text{C3} \times \text{V3} + \text{C4} \times \text{V4}$$

$$\text{C1} + \text{C2} = \text{C3} + \text{C4},$$

where V1 is the voltage value of the first preset voltage V1, V2 is the voltage value of the second preset voltage V2, V3 is the voltage value of the third preset voltage V3, V4 is the voltage value of the fourth preset voltage V4, C1 is the capacitance of the first weighted capacitor C1, C2 is the capacitance of the second weighted capacitor C2, C3 is the capacitance of the third weighted capacitor C3, and C4 is the capacitance of the fourth weighted capacitor C4.

It should be noted that the first weighted capacitor C1, the second weighted capacitor C2, the third weighted capacitor C3, or the fourth weighted capacitor C4 can be a single capacitor or a plurality of capacitors. Taking FIG. 16 as an example, the first weighted capacitor C1 can be the first capacitors C11 and C12 connected in parallel, the second weighted capacitor C2 can be the first capacitors C13, C14, ..., and C1n connected in parallel, the third weighted capacitor C3 can be the second capacitors C21 and C22 connected in parallel, and the fourth weighted capacitor C4 can be the second capacitors C23, C24, ..., and C2n connected in parallel.

In the above embodiments, since the first preset voltage V1, the second preset voltage V2, the third preset voltage V3, the fourth preset voltage V4, the first weighted capacitor C1, the second weighted capacitor C2, the third weighted capacitor C3, and the fourth weighted capacitor C4 satisfy the above relationship, according to the relationship between voltage, capacitance, and charge, the following relationship can be obtained after charge redistribution:

$$(\text{C1} \times \text{V1} + \text{C2} \times \text{V2}) / (\text{C1} + \text{C2}) = (\text{C3} \times \text{V3} + \text{C4} \times \text{V4}) / (\text{C3} + \text{C4}).$$

Therefore, during the sampling phase, the output voltages at the capacitor connected to the first switch S1 and the capacitor connected to the second switch S2 of the DAC 100 are equal, thereby completing the sampling process of the DAC 100.

In some embodiments of the present application, the capacitance of the first weighted capacitor C1 is equal to the capacitance value of the third weighted capacitor C3, and the capacitance value of the second weighted capacitor C2 is equal to the capacitance value of the fourth weighted capacitor C4. The voltage value of the first preset voltage V1 is equal to the voltage value of the third preset voltage V3, and the voltage value of the first preset voltage V1 is equal to the voltage value of the third preset voltage V3.

In some embodiments of the present application, the second capacitors correspond one-to-one with the first capacitors, and each of the first capacitors and each of the second capacitors have the same capacitance. The first redistribution switches S01, which are configured to be open and then closed synchronously, are positioned opposite to the second redistribution switch S02, respectively, so as to ensure that the capacitance of the first weight capacitor C1 is equal to the capacitance of the third weight capacitor C3, and the capacitance of the second weight capacitor C2 is equal to the capacitance of the fourth weight capacitor C4.

For example, taking FIG. 16 as an example, the first redistribution switch S01, which is configured to be open and then closed, is located between the first capacitor C11 and the first capacitor C12 . The second redistribution switch S02, which is configured to be open and then closed, is located between the second capacitor C21 and the second capacitor C22 . That is, the first weight capacitor C1 includes the first capacitor C11, the second weight capacitor C2 includes the first capacitor C12, C13, ..., and C1n, the third weight capacitor C3 includes the second capacitor C21, and the fourth weight capacitor C4 includes the second capacitor C22, C22, ..., and C2n. Since the second capacitors corresponds one-to-one with the first capacitors and each of the first capacitors and each of the second capacitors have the same capacitance, it can be guaranteed that the capacitance of the first weight capacitor C1 is equal to the capacitance of the third weight capacitor C3, and the capacitance of the second weight capacitor C2 is equal to the capacitance of the fourth weight capacitor C4.

In some embodiments of the present application, referring to FIG. 19, which schematically shows yet another example of a circuit of a first switch capacitor unit 10 according to some embodiments of the present application, the first switch network 12 includes a first switch S1, a second switch S2, and a first redistribution switch S01. One end of the first switch S1 is connected to the first-side plate of the first weighted capacitor $C_1$, and the other end is used to receive a first preset voltage V1. One end of the second switch S2 is connected to the first-side plate of the second weighted capacitor C2, and the other end is used to receive a second preset voltage V2. One end of the first redistribution switch S01 is connected to the first node M1 between the first weighted capacitor C1 and the first switch S1, and the other end is connected to the second node M2 between the second weighted capacitor C2 and the second switch S2. The first preset voltage V1 and the second preset voltage V2 are not equal.

The third switch network 22 includes a third switch S3, a fourth switch S4, and a second redistribution switch S02. One end of the third switch S3 is connected to the first-side plate of the third weight capacitor C3, and the other end is used to receive the third preset voltage V3. One end of the fourth switch S4 is connected to the first-side plate of the fourth weight capacitor C4, and the other end is used to receive the fourth preset voltage V4. One end of the second redistribution switch S02 is connected to the third node M3 between the third weight capacitor C3 and the third switch S3, and the other end is connected to the fourth node M4 between the fourth weight capacitor C4 and the fourth switch S4. The third preset voltage V3 and the fourth preset voltage V4 are not equal.

When the first switch S1, the second switch S2, the third switch S3, and the fourth switch S4 are closed, and the first redistribution switch S01 and the second redistribution switch S02 are open, the first preset voltage V1 charges the first weighted capacitor C1, the second preset voltage V2 charges the second weighted capacitor C2, the third preset voltage V3 charges the third weighted capacitor C3, and the fourth preset voltage V4 charges the fourth weighted capacitor C4. When the first switch S1, the second switch S2, the third switch S3, and the fourth switch S4 are open, and the first redistribution switch S01 and the second redistribution switch S02 are closed, the charges on the first-side plates of the first weighted capacitor C1 and the second weighted capacitor C2 are redistributed and a common-mode voltage Vcm is output, and simultaneously the charges of the first-side plates of the third weighted capacitor C3 and the fourth weighted capacitor C4 are redistributed and a common-mode voltage Vcm is output, thereby realizing the sampling establishment process of the DAC 100.

It should be understood that the capacitance of the first weighted capacitor C1, the second weighted capacitor C2, the third weighted capacitor C3, or the fourth weighted capacitor C4 can also change with the change of the position of the first redistribution switch S01 and the second redistribution switch S02 which are configured to be open and then closed. For example, taking FIG. 16 as an example, when the first redistribution switch S01 configured to be open and then closed is located between the first-side plate of the first capacitor Cl(n-1) and Cln, the capacitance of the first weighted capacitor C1 equals a sum of capacitances of the first capacitors C11, C12, ..., C1(n-1), and the capacitance of the second weighted capacitor C2 equals the capacitance of the first capacitor C1n.

It is noted that the above content regarding the DAC is intended to clearly illustrate the implementation and verification process of the present application. Those skilled in the art can make equivalent modifications under the guidance of the present application. For example, some switches (such as the first switch S1, the second switch S2, the third switch S3, or the fourth switch S4, etc.) can be placed outside the analog-to-digital converter; or, for example, the switches (such as the first redistribution switch S01, the second redistribution switch S02, etc.) can be transistors with switching functions, such as MOSFETs, IGBTs, or triodes.

The embodiments of the present application also provides an analog-to-digital converter (ADC), which includes the aforementioned DAC 100. The ADC can be, but is not limited to, a successive approximation register-type ADC, or a hybrid ADC composed of a successive approximation ADC and other ADCs, such as a pipeline-SAR ADC, incremental-SAR ADC, delta-sigma-SAR ADC, etc. During the sampling phase, the ADC enables the second-side plates of the first capacitor network 11 to receive the analog input voltage VIN, causing a charge redistribution on the first-side plates of the first capacitor network 11 to generate a common-mode voltage Vcm. Simultaneously, the second switch capacitor unit 20 provides the common-mode voltage Vcm through a charge redistribution on the first-side plates of the second capacitor network 21, thereby completing the sampling process of the analog input voltage VIN by the ADC. In other words, during the sampling setup process, there is no need for an external common-mode voltage generation module to provide the common-mode voltage Vcm, nor is it necessary to apply the common-mode voltage Vcm to the first-side plates of the first capacitor network 11. The charge redistributions of the first-side plates of each of the first capacitor network 11 and the second capacitor network 21 are respectively performed to complete the sampling process of the analog input voltage VIN. On the one hand, this eliminates the need for a common-mode voltage generation module in the ADC (e.g., a successive approximation ADC), simplifying the circuit structure of the ADC. On the other hand, since the common-mode voltage Vcm is provided through the charge redistribution, the outputting of the common-mode voltage Vcm consumes virtually no power, thus reducing the power consumption of the ADC.

The embodiments of the present application also provides a chip that may include the ADC described above. The chip may be an integrated circuit (IC), also known as a microcircuit, microchip, or wafer/chip. The chip may be, but is not limited to, a system-on-chip (SOC) or system-in- package (SIP) chip.

In this chip, the ADC enables the second-side plates of the first capacitor network 11 to receive the analog input voltage VIN during the sampling phase. This causes charge redistribution on the first-side plates of the first capacitor network 11, generating a common-mode voltage Vcm. Simultaneously, the second switch capacitor unit 20 provides the common-mode voltage Vcm through the charge redistribution on the first-side plates of the second capacitor network 21, thus completing the sampling process of the ADC for the analog input voltage VIN. In other words, during the sampling setup process, there is no need for an external common-mode voltage generation module to provide the common-mode voltage Vcm, nor is it necessary to apply the common-mode voltage Vcm to the first-side plates of the first capacitor network 11. The charge redistributions of the first-side plates of each of the first capacitor network 11 and the second capacitor network 21 are respectively performed to complete the sampling process of the analog input voltage VIN. This eliminates the need for a common-mode voltage generation module in ADCs (such as successive approximation ADCs), simplifying the ADC's circuit structure. Furthermore, because the common-mode voltage Vcm is provided through charge redistribution, the outputting of the common-mode voltage Vcm process consumes virtually no power, thus reducing the power consumption of the ADC.

The embodiments of the present application also provides an electronic device, which may include a device body and a chip or ADC as described above disposed within the device body. The electronic device may be, but is not limited to, a weight scale, body fat scale, nutrition scale, infrared electronic thermometer, pulse oximeter, body composition analyzer, power bank, wireless charger, fast charger, car charger, adapter, display, universal serial bus (USB) docking station, stylus, true wireless stereo (TWS) earphones, car's center console screen, automobile, smart wearable device, mobile terminal, and smart home device.

The wearable devices include, but are not limited to, smartwatches, smart bracelets, and neck massagers. Mobile terminals include, but are not limited to, smartphones, laptops, tablets, and point-of-sale (POS) terminals. Smart home devices include, but are not limited to, smart sockets, smart rice cookers, smart robot vacuums, and smart lights.

In this electronic device, the ADC enables the second-side plates of the first capacitor network 11 to receive the analog input voltage VIN during the sampling phase. This causes charge redistribution on the first-side plates of the first capacitor network 11, generating a common-mode voltage Vcm. Simultaneously, the second switch capacitor unit 20 provides the common-mode voltage Vcm through the charge redistribution on the first-side plates of the second capacitor network 21, thus completing the sampling process of the ADC for the analog input voltage VIN. In other words, during the sampling setup process, there is no need for an external common-mode voltage generation module to provide the common-mode voltage Vcm, nor is it necessary to apply the common-mode voltage Vcm to the first-side plates of the first capacitor network 11. The charge redistributions of the first-side plates of each of the first capacitor network 11 and the second capacitor network 21 are respectively performed to complete the sampling process of the analog input voltage VIN. This eliminates the need for a common-mode voltage generation module in the ADC (e.g., a successive approximation ADC), simplifying the ADC's circuit structure. Furthermore, since the common-mode voltage Vcm is provided through the charge redistribution, the outputting of the common-mode voltage Vcm consumes virtually no power, thus reducing the ADC's power consumption.

The above are merely some embodiments of the present application and are not intended to limit the present application in any way. Although the present application has disclosed some embodiments as above, it is not intended to limit the present application. Any person skilled in the art can make some modifications or alterations to the above-disclosed technical content to create equivalent embodiments without departing from the scope of the technical solution of the present application. Any simple modifications, equivalent changes and alterations made to the above embodiments based on the technical essence of the present application without departing from the scope of the technical solution of the present application shall still fall within the scope of the technical solution of the present application.

**Claims**

1. A digital-to-analog converter, comprising:

   a first switch capacitor unit comprising a first capacitor network;
   a second switch capacitor unit comprising a second capacitor network,
   wherein the second switch capacitor unit is configured to redistribute charge on first plates of the second capacitor network and output a common-mode voltage;
   the first switch capacitor unit is configured to, during a sampling phase, apply an analog input voltage to second plates of the first capacitor network and redistribute charge on first plates of the first capacitor network to output the common-mode voltage.

2. The digital-to-analog converter according to claim 1, wherein the first switch capacitor unit further comprises a first switch network and a second switch network;

   the first switch network is connected to first plates of the first capacitor network, and the second switch network is connected to second plates of the first capacitor network;
   the first switch network is configured to control redistribution of the charge on the first plates to output the common-mode voltage, and the second switch network is configured to switch a voltage applied to each of the second plates, so that the charge on the first plates is redistributed again to output an analog output voltage.

3. The digital-to-analog converter according to claim 2, wherein the first capacitor network comprises a plurality of first capacitors, the first plates of the first capacitors are interconnected;

   the first switch network comprises at least one first redistribution switch for connecting or disconnecting two of the first plates, respectively belonging to two adjacent ones of the first capacitors, with each other; and
   in a case where the first redistribution switch is turned off, at least potentials respectively at the two of the first plates are not equal to each other, and in a case where the first redistribution switch is turned on, the charge on the first plates is redistributed.

4. The digital-to-analog converter according to claim 3, wherein one of the at least one first redistribution switch is provided between two of the first plates respectively belonging to any two adjacent ones of the first capacitors; and during the sampling phase, at most one of the at least one first redistribution switch is configured to be turned off prior to being turned on.

5. The digital-to-analog converter according to claim 4, wherein the first capacitors are sequentially arranged in an array; and
   one of the first plates belonging to one of the first capacitors located at a head of the array is configured to receive a first preset voltage, and another one of the first plates belonging to one of the first capacitors located at an end of the array is configured to receive a second preset voltage not equal to the first preset voltage.

6. The digital-to-analog converter according to claim 5, wherein the first switch network further comprises a first switch and a second switch;

   the first switch has a terminal connected to the one of the first plates belonging to the one of the first capacitors located at the head of the array, and another terminal for receiving the first preset voltage; and
   the second switch has a terminal connected to the another one of the first plates belonging to the one of the first capacitors located at the end of the array, and another terminal for receiving the second preset voltage.

7. The digital-to-analog converter according to claim 5 or 6, wherein the second switch network comprises a plurality of first control switches respectively corresponding to the first capacitors;

the first control switch is configured to switch between applying the analog input voltage to the second plate of the first capacitor, applying a reference voltage to the second plate, and grounding the second plate; and
the first preset voltage and the second preset voltage are any two of the reference voltage, a power supply voltage, and a voltage of 0 V.

8. The digital-to-analog converter according to claim 2, wherein the second switch capacitor unit further comprises a third switch network;
the third switch network is connected to the first plates of the second capacitor network, and is configured to control redistribution of the charge on the first plates of the second capacitor network to output the common-mode voltage.

9. The digital-to-analog converter according to claim 8, wherein the second capacitor network comprises a plurality of second capacitors, the first plates of the second capacitors are interconnected;

the third switch network comprises at least one second redistribution switch for connecting or disconnecting two of the first plates, respectively belonging to two adjacent ones of the second capacitors, with each other; and
in a case where the second redistribution switch is turned off, at least potentials respectively at the two of the first plates are not equal to each other, and in a case where the second redistribution switch is turned on, the charge on the first plates is redistributed.

10. The digital-to-analog converter according to claim 9, wherein one of the at least one second redistribution switch is provided between two of the first plates respectively belonging to any two adjacent ones of the second capacitors; and
at most one of the at least one second redistribution switch is configured to be turned off prior to being turned on.

11. The digital-to-analog converter according to claim 10, wherein the second capacitors are sequentially arranged in an array; and
one of the first plates belonging to one of the second capacitors located at a head of the array is configured to receive a third preset voltage, and another one of the first plates belonging to one of the second capacitors located at an end of the array is configured to receive a fourth preset voltage not equal to the third preset voltage.

12. The digital-to-analog converter according to claim 11, wherein the third switch network further comprises a third switch and a fourth switch;

the third switch has a terminal connected to the one of the first plates belonging to the one of the second capacitors located at the head of the array, and another terminal for receiving the third preset voltage; and
the fourth switch has a terminal connected to the another one of the first plates belonging to the one of the second capacitors located at the end of the array, and another terminal for receiving the fourth preset voltage.

13. The digital-to-analog converter according to claim 12, wherein the third preset voltage and the fourth preset voltage are any two of a reference voltage, a power supply voltage, and a voltage of 0 V.

14. The digital-to-analog converter according to claim 12, wherein a preset holding voltage is applied to the second plates of the second capacitors; or
the second switch capacitor unit further comprises a fourth switch network, the fourth switch network comprises a plurality of second control switches respectively corresponding to the second capacitors, and each of the second control switches is configured to switch between applying a reference voltage to the second plate of the second capacitor, and grounding the second plate.

15. The digital-to-analog converter according to claim 8, wherein the first capacitor network comprises a first weighted capacitor and a second weighted capacitor, and the second capacitor network comprises a third weighted capacitor and a fourth weighted capacitor;

the first plate of the first weighted capacitor is configured to receive a first preset voltage, the first platen of the second weighted capacitor is configured to receive a second preset voltage, the first plate of the third weighted capacitor is configured to receive a third preset voltage, the first plate of the fourth weighted capacitor is configured to receive a fourth preset voltage; and

$$C1 \times V1 + C2 \times V2 = C3 \times V3 + C4 \times V4$$

$$C1 + C2 = C3 + C4 \,,$$

where V1 represents a voltage value of the first preset voltage, V2 represents a voltage value of the second preset voltage, V3 represents a voltage value of the third preset voltage, V4 represents a voltage value of the fourth preset voltage, C1 represents a capacitance of the first weighted capacitor, C2 represents a capacitance of the second weighted capacitor, C3 represents a capacitance of the third weighted capacitor, and C4 represents a capacitance of the fourth weighted capacitor.

16. The digital-to-analog converter according to claim 15, wherein C1 = C3 , C2 = C4 , V1 = V3 , and V1 = V3.

17. The digital-to-analog converter according to claim 15, wherein the first switch network comprises a first switch, a second switch and a first redistribution switch;

the first switch has a terminal connected to the first plate of the first weighted capacitor, and another terminal for receiving the first preset voltage;
the second switch has a terminal connected to the first plate of the second weighted capacitor, and another terminal for receiving the second preset voltage;
the first redistribution switch has a terminal connected to a first node between the first weighted capacitor and the first switch, and another terminal connected to a second node between the second weighted capacitor and the second switch; and
the first preset voltage is not equal to the second preset voltage.

18. An analog-to-digital converter comprising the digital-to-analog converter according to any one of claims 1-17.

19. A chip comprising the analog-to-digital converter according to claim 18.

20. An electronic device comprising a device body and the chip according to claim 19 disposed within the device body.

FIG. 1

FIG. 2

sampling phase          conversion phase

FIG. 3

FIG. 4

$C_0$

$V_0$

Sc1

Sc2

Vout

11

$C_1$

$C_2$

FIG. 5

13

Vcm/
Vdac

12

VIN

Vref

gnd

second
switch
network

first
switch
network

V1

V2

11

FIG. 6

sampling phase

$$VCm=(V1\times C_{11}+V2\times C_{12})/(C_{11}+C_{12})$$

FIG. 7

FIG. 8

FIG. 9

sampling phase

FIG. 10

FIG. 11

FIG. 12

$$Vcm=(V3 \times C_{21}+V4 \times C_{22})/(C_{21}+C_{22})$$

FIG. 13

FIG. 14

FIG. 15

FIG. 16

FIG. 17

FIG. 18

FIG. 19

## INTERNATIONAL SEARCH REPORT

| International application No. |
| --- |
| **PCT/CN2024/119774** |

| A. | CLASSIFICATION OF SUBJECT MATTER |
| --- | --- |

H03M1/12(2006.01)i;  H03M1/44(2006.01)i;  H03M1/00(2006.01)i

According to International Patent Classification (IPC) or to both national classification and IPC

| B. | FIELDS SEARCHED |
| --- | --- |

Minimum documentation searched (classification system followed by classification symbols)

IPC:H03M

Documentation searched other than minimum documentation to the extent that such documents are included in the fields searched

Electronic data base consulted during the international search (name of data base and, where practicable, search terms used)

CNTXT, ENTXT, DWPI, CNKI: 数模转换器, 电容, 开关, 极板, 电荷, 再分配, 共模电压, 共模电平, digital, analog, converter, capacitor, switch, plate, charge, redistribute, common, voltage

| C. | DOCUMENTS CONSIDERED TO BE RELEVANT | |
| --- | --- | --- |

| Category* | Citation of document, with indication, where appropriate, of the relevant passages | Relevant to claim No. |
| --- | --- | --- |
| PX | CN 117118444 A (XI'AN XINHAI MICROELECTRONIC TECHNOLOGY CO., LTD.) 24 November 2023 (2023-11-24) claims 1-20 | 1-20 |
| PX | CN 221151351 U (XI'AN XINHAI MICROELECTRONIC TECHNOLOGY CO., LTD. et al.) 14 June 2024 (2024-06-14) claims 1-18, description, paragraphs 55-139, and figures 1-18 | 1-20 |
| A | CN 108039890 A (ZHUHAI GREE ELECTRIC APPLIANCES INC.) 15 May 2018 (2018-05-15) description, paragraphs 55-112, and figures 1-7 | 1-20 |
| A | US 2011043394 A1 (ST MICROELECTRONICS S.R.L.) 24 February 2011 (2011-02-24) entire document | 1-20 |

☐ Further documents are listed in the continuation of Box C.   ☑ See patent family annex.

| * Special categories of cited documents: | "T" later document published after the international filing date or priority date and not in conflict with the application but cited to understand the principle or theory underlying the invention |
| --- | --- |
| "A" document defining the general state of the art which is not considered to be of particular relevance | |
| "D" document cited by the applicant in the international application | "X" document of particular relevance; the claimed invention cannot be considered novel or cannot be considered to involve an inventive step when the document is taken alone |
| "E" earlier application or patent but published on or after the international filing date | |
| "L" document which may throw doubts on priority claim(s) or which is cited to establish the publication date of another citation or other special reason (as specified) | "Y" document of particular relevance; the claimed invention cannot be considered to involve an inventive step when the document is combined with one or more other such documents, such combination being obvious to a person skilled in the art |
| "O" document referring to an oral disclosure, use, exhibition or other means | |
| "P" document published prior to the international filing date but later than the priority date claimed | "&" document member of the same patent family |

| Date of the actual completion of the international search | Date of mailing of the international search report |
| --- | --- |
| **14 October 2024** | **26 December 2024** |

| Name and mailing address of the ISA/CN | Authorized officer |
| --- | --- |
| **China National Intellectual Property Administration (ISA/ CN)** **China No. 6, Xitucheng Road, Jimenqiao, Haidian District, Beijing 100088** | |
| | Telephone No. |

Form PCT/ISA/210 (second sheet) (July 2022)

## INTERNATIONAL SEARCH REPORT
**Information on patent family members**

International application No.

**PCT/CN2024/119774**

| Patent document cited in search report | | | Publication date (day/month/year) | Patent family member(s) | | | Publication date (day/month/year) |
|---|---|---|---|---|---|---|---|
| CN | 117118444 | A | 24 November 2023 | None | | | |
| CN | 221151351 | U | 14 June 2024 | None | | | |
| CN | 108039890 | A | 15 May 2018 | None | | | |
| US | 2011043394 | A1 | 24 February 2011 | US | 8264389 | B2 | 11 September 2012 |

Form PCT/ISA/210 (patent family annex) (July 2022)

**EP 4 773 513 A1**

REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- CN 202311258513